Europäisches Patentamt

**European Patent Office**

Office européen des brevets

(11) Veröffentlichungsnummer: **0 089 401**

**A2**

(12) **EUROPÄISCHE PATENTANMELDUNG**

(21) Anmeldenummer: **82104699.2**

(22) Anmeldetag: **28.05.82**

(51) Int. Cl.³: **G 12 B 15/04**

(30) Priorität: **19.03.82 CH 1704/82**

(43) Veröffentlichungstag der Anmeldung:
**28.09.83 Patentblatt 83/39**

(84) Benannte Vertragsstaaten:
**CH DE GB IT LI NL**

(71) Anmelder: **SIEMENS-ALBIS AKTIENGESELLSCHAFT**
**EGA1/Verträge und Patente Postfach**
**CH-8047 Zürich(CH)**

(72) Erfinder: **Alder, Jakob**
**Bleicherstrasse 18**
**CH-8953 Dietikon(CH)**

(54) **Zwangsbelüfteter Baugruppenträger.**

(57) Der Baugruppenträger (11), der zur Abkühlung einem aufsteigenden Luftstrom ausgesetzt ist, ist als Kofferrahmen (30) ausgebildet, der vorne eine Frontplatte (41) und hinten eine Abdeckung (42) aufweist. Dadurch wird der baugruppenträger (11) weitgehend gegen elektromagnetische Strahlung abgeschirmt. Zur Belüftung sind an der unteren und oberen Seite des Baugruppenträgers (11) luftdurchlässige Bereiche (34 bzw. 35) vorgesehen.

FIG.3

EP 0 089 401 A2

Croydon Printing Company Ltd

**0089401**

Zwangsbelüfteter Baugruppenträger

Die vorliegende Erfindung betrifft einen zwangsbelüfteten Baugruppenträger gemäss dem Oberbegriff des Patentanspruches 1.

Zum Aufbau elektrischer Geräte, beispielsweise für Telefon-, Telex-, Radar- oder Steueranlagen, werden vielfach Gestelle verwendet, in denen mit elektrischen Bauteilen bestückte Baugruppen von vorne senkrecht in Einschubrahmen des Gestells einschiebbar sind, wobei beim Einschieben die Baugruppen durch Stecker mit der elektrischen Schaltung oder der Verdrahtung des Gestells verbunden werden. Bei derartigen Anlagen werden oft relativ strenge Anforderungen an die elektromagnetische Abschirmung der Bauteile gestellt, was dazu führt, die Gestelle als geschlossene Schränke auszubilden und die von den Baugruppen erzeugte Wärme durch Zwangsbelüftung abzuführen.

Der vorliegenden Erfindung liegt die Aufgabe zugrunde, einen zwangsbelüfteten Baugruppenträger dahingehend auszubilden, dass er zugleich sehr hohen Anforderungen bezüglich der elektromagnetischen Abschirmung genügt.

Dies wird erfindungsgemäss durch die im kennzeichnenden Teil des Anspruches 1 angegebenen Massnahmen erreicht. Vorteilhafte Ausgestaltungen der Erfindung sind in weiteren Ansprüchen angegeben.

Im folgenden wird die Erfindung anhand eines in der Zeichnung schematisch dargestellten Ausführungsbeispiels näher erläutert. Es zeigt :

Fig.1 die schematische Darstellung eines schrankförmigen Gestells mit zwangsbelüfteten Baugruppenträgern

Fig.2 eine perspektivische Darstellung des Kofferrahmens eines solchen Baugruppenträgers

Fig.3 eine schematische Darstellung dieses Baugruppenträgers in einem Schnittbild

Fig.4 und 5 eine Draufsicht einer an der Rückseite des Koffers angeordneten Haube

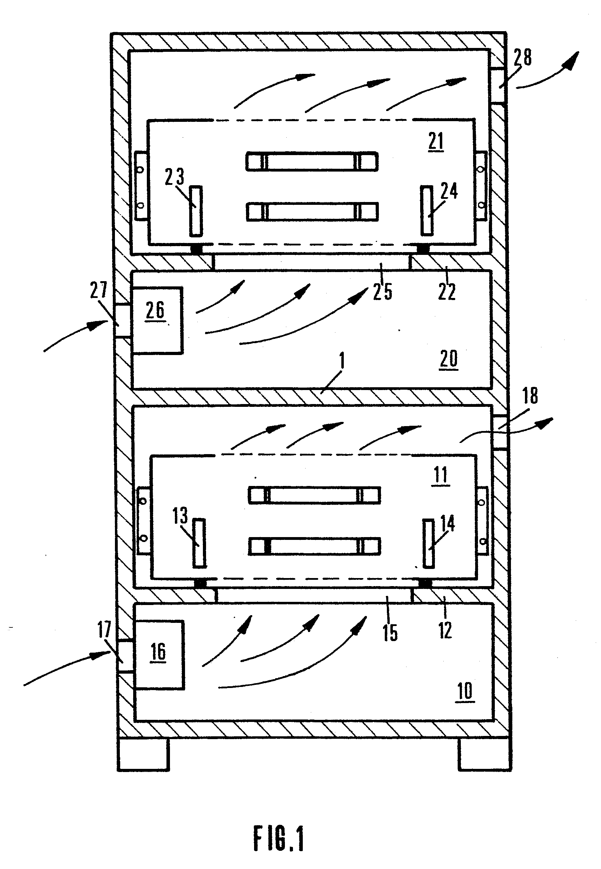

Das schrankförmige Gestell nach Fig.1 ist durch eine waagerechte Trennwand 1 in zwei Räume 10 und 20 aufgeteilt, in denen je eine Regalplatte 12 bzw. 22 vorhanden ist, auf der jeweils ein Baugruppenträger 11 bzw. 21 untergebracht ist. Die Baugruppenträger sind kofferförmig ausgebildet und weisen an ihrer Vorderseite je einen linken Griff 13 bzw. 23 und einen rechten Griff 14 bzw. 24 auf. Die untere und obere Wand der Baugruppenträger ist wenigstens teilweise mit vielen kleinen gitterförmig verteilten Bohrungen versehen, die in Fig. 1 schematisch durch gestrichelte Linien dargestellt sind. Die Regalplatten 12 und 22 sind in der Mitte mit einem Ausschnitt 15 bzw. 25 versehen, der sich unmittelbar unter dem gelochten Bereich der unteren Wand des daraufliegenden Baugruppenträgers 11 bzw. 21 befindet. Im unteren Teil der Räume 10 und 20 ist je ein Ventilator 16 bzw. 26 neben einer Lüftungsöffnung 17 bzw. 27 an einer Seitenwand des Gestells vorhanden, dessen andere Seitenwand mit weiteren Oeffnungen 18 bzw. 28 für den Luftaustritt versehen ist.

Die Anlage nach Fig. 1 funktioniert folgendermassen :
Die Luft wird beispielsweise vom Ventilator 16 in den Raum 10 angesaugt, strömt durch die Oeffnung 15 der Regalplatte 12 und durch die Bohrungen an der unteren und oberen Wand des Baugruppenträgers 11 hindurch und tritt durch die Oeffnung 18 aus dem Gestell heraus. Der Verlauf der Kühlluft ist in Fig. 1 durch Pfeile angedeutet.

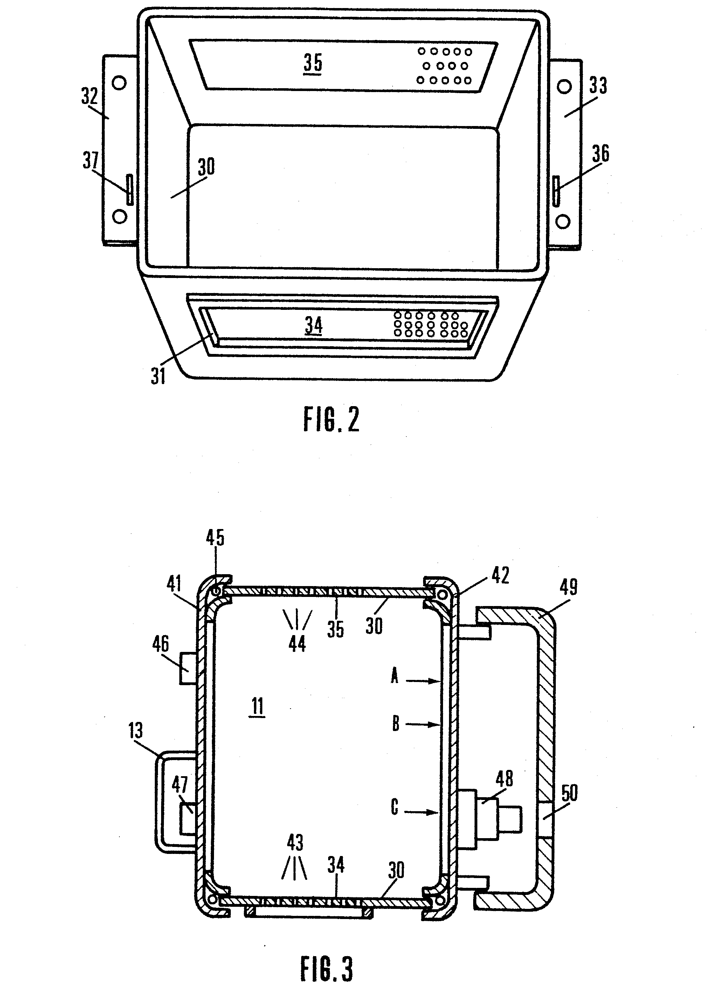

Der in Fig. 2 perspektivisch dargestellte Kofferrahmen 30 umfasst vier Seitenwände, von denen die untere und die obere je einen gelochten Bereich 34 bzw. 35 aufweisen. Die Bereiche 34, 35 sind mit vielen kleinen gitterförmig verteilten Bohrungen versehen. Dabei ist der gelochte Bereich der unteren Seitenwand mit einem dünnen Kunststoffrahmen 31 umrandet, der als Auflage- und Gleitfläche des Baugruppenträgers auf der Regalplatte 12 bzw. 22 (Fig. 1) dient. Durch diesen Kunststoffrahmen 31 wird ein Entweichen der Luft aus dem gewünschten Luftweg weitgehend vermieden. An der linken und rechten Seitenwand des Kofferrahmens 30 sind Rahmenhalterungen 32 und 33 angebracht, die durch Schrauben, Klemmen, Magnete oder dgl. am Gestell befestigt werden können. Die Steifheit des Kofferrahmens lässt sich in bekannter Weise mit Hilfe von in der Figur nicht dargestellten Eckpfosten und Profilteilen verbessern.

Die Baugruppenträger 11 und 21 nach Fig. 1 sind vorne mit einer Frontplatte 41 (Fig.3) und hinten mit einer Abdeckung 42 (Fig.3) versehen. Durch die Frontplatte 41 und die Abdeckung 42 wird der Baugruppenträger weitgehend gegen elektromagnetische Strahlung abgeschirmt. Kleine Bohrungen an einer Metallplatte bewirken bekanntlich nur eine unbedeutende Verschlechterung der Abschirmung der Platte, wie im Buch "EMC-Elektromagnetische Verträglichkeit", von Dieter Stoll, Hrsg.,1976, Elitera-Verlag, Berlin 33, Seite 74ff ausgeführt wird. Dabei ist es wichtig, dass eine einwandfreie elektrische Kontaktgabe zwischen dem Kofferrahmen 30 (Fig.3) und der Frontplatte 41 bzw. der Abdeckung 42 gewährleistet ist. Hierzu ist die Umrandung der Frontplatte 41 und der Abdeckung 42 nutenförmig ausgebildet. Die Kanten des Kofferrahmens 30 greifen ringsum in diese Nut ein. Dabei kann ringsum in der Nut noch eine metallische Abschirmschnur 45 eingebettet sein.

Wie aus Fig. 3 ersichtlich, können daher die Frontplatte 41 und die Abdeckung 42 ähnlich aufgebaut sein. Die Frontplatte 41 weist jedoch zusätzlich zwei Griffe (13 in Fig.3 und 13 bzw. 14 in Fig.1) und zwei Tragriemen 46 und 47 auf. Die Abdeckung 42 weist hingegen mindestens eine in Fig. 3 beispielsweise an den Stellen A, B und/oder C angedeutete Durchführung auf, die zum Anschluss elektrischer Verbindungskabel aus dem Innern des Baugruppenträgers an mindestens eine an der Aussenseite der Abdeckung 42 angeordnete Steckdose 48 dienen, wobei anstelle der Steckdosen auch Stecker verwendet werden können. Fig. 3 zeigt zudem eine nicht vollständig montierte Haube 49 im Schnitt, die zum Schutz der Steckdosen bzw. Stecker 48 dient. Die Haube 49 weist mehrere Oeffnungen 50 auf, die einen Kontakt zwischen den Steckern bzw. Steckdosen 48 und ihren Gegenstücken im Gestell ermöglichen. Im Baugruppenträger sind Baugruppen untergebracht, die aus bestückten gedruckten Leiterplatten bestehen können.

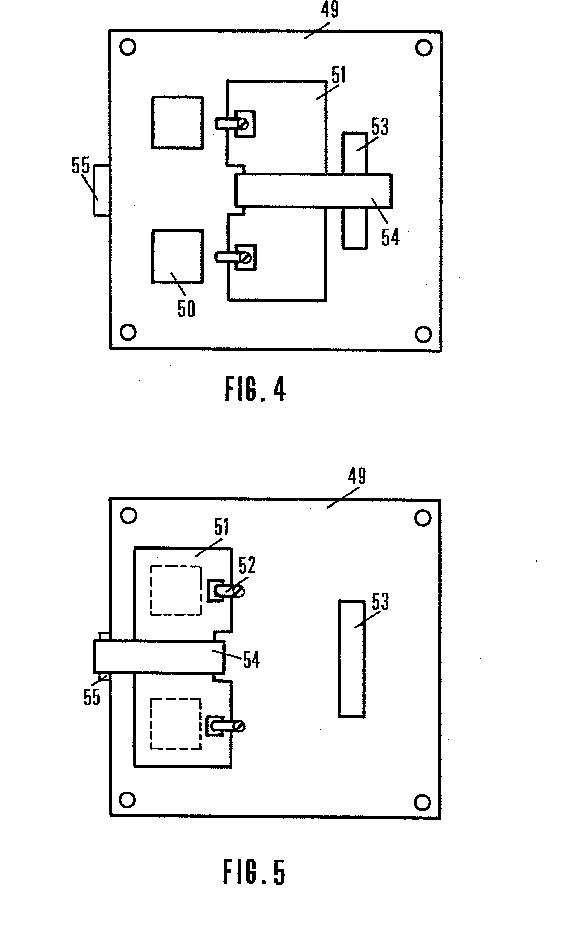

Wenn der Baugruppenträger nicht im Gestell eingesetzt ist, können die Oeffnungen 50 der in Fig. 3 dargestellten Haube 49 mittels einer Abdeckplatte 51 abgeschlossen werden. Diese Abdeckplatte 51 ist mit Hilfe von Scharnieren oder Angeln 52 an der Aussenfläche der Haube 49 derart umklappbar befestigt, dass die Abdeckplatte 51 die Oeffnungen 50 entweder frei lässt (Fig.4) oder zudeckt (Fig.5). In beiden Positionen kann die Abdeckplatte mit Adhärent-Kunststoff-Streifen 53, 54, 55 gehalten werden.

In Fig.3 sind die Steckdosen bzw. Stecker 48 an der Abdeckung 42 befestigt. Sie könnten jedoch auch bei der Oeffnung 50 an der Haube 49 angeordnet sein. Die Rahmenhalterungen 32 und 33 können Schlitze 36 und 37 aufweisen, durch die federnde Arretierungslamellen hindurchgeführt sind, um die Rahmenhalterungen von aussen her zu entriegeln. An der Haube 49 und am Gestell können in bekannter Weise Mittel vorgesehen werden, um das Einschieben eines Baugruppenträgers an einer falschen Stelle im Gestell zu verhindern. Das Gestell nach Fig.1 kann mit einer hermetisch verschliessbaren Tür versehen sein. Der erfindungsgemässe Baugruppenträger kann selbstverständlich auch in Gestellen anderer Art nach dem Stand der Technik, beispielsweise in einem solchen mit nur einem Ventilator für mehrere Etagen, verwendet werden.

Zur Belüftung der Gestelle können auch flache, sogenannte kompakte Etagenlüfter eingesetzt werden, die mit einer Lüfterwalze versehen und daher für Baugruppenträger geeignet sind.

## PATENTANSPRUECHE

1. Zwangsbelüfteter Baugruppenträger, der zur Abkühlung einem aufsteigenden Luftstrom ausgesetzt ist, d a d u r c h  g e k e n n z e i c h n e t, dass der Baugruppenträger (11) als Kofferrahmen (30) ausgebildet ist, der an der Vorderseite eine Frontplatte (41) und an der Rückseite eine Abdeckung (42) aufweist, und dass die Unter- und die Oberseite des Baugruppenträgers (11) wenigstens teilweise luftdurchlässig ist.

2. Baugruppenträger nach Anspruch 1, d a d u r c h  g e k e n n z e i c h n e t, dass die Umrandung der Frontplatte (41) und/oder der Abdeckung (42) nutenförmig ausgebildet ist, und dass die Kanten des Kofferrahmens (30) ringsum in diese Nut eingreifen.

3. Baugruppenträger nach Anspruch 1 oder 2, d a d u r c h  g e k e n n z e i c h - n e t , dass die Abdeckung (42) mit mindestens einer Durchführung für elektrische Leitungen (A, B, C) versehen ist.

4. Baugruppenträger nach Anspruch 3, d a d u r c h  g e k e n n z e i c h n e t, dass die Aussenseite der Abdeckung (42) mit einer Haube (49) geschützt ist, die mindestens eine Oeffnung (50) auf der Höhe einer Steckdose (48) oder eines Steckers (48) aufweist.

5. Baugruppenträger nach Anspruch 4, d a d u r c h  g e k e n n z e i c h n e t, dass an der Aussenseite der Haube (49) eine Abdeckplatte (51) umklappbar befestigt ist (Fig.5).

0089401
82P9804

FIG.1

82P9804
0089401

FIG. 2

FIG. 3

82P9804

**0089401**

FIG. 4

FIG. 5